Europäisches Patentamt

European Patent Office

Office européen des brevets

(19)

(11)  **EP 1 001 273 B1**

(12)  **EUROPÄISCHE PATENTSCHRIFT**

(45)  Veröffentlichungstag und Bekanntmachung des Hinweises auf die Patenterteilung:
**26.01.2005  Patentblatt 2005/04**

(51)  Int Cl.$^7$: **G01R 31/3185**

(21)  Anmeldenummer: **99122499.9**

(22)  Anmeldetag: **11.11.1999**

(54)  **Integrierter Halbleiterchip mit über Bondpads voreingestellter Dateneingabe-/Datenausgabe-Organisationsform**

Integrated semiconductor chip with preset input output configuration over bond pads

Circuit intégré semiconducteur avec configuration d'entrée et de sortie prédéfinies par plages de contacts

(84)  Benannte Vertragsstaaten:
**DE FR GB IE IT**

(30)  Priorität: **11.11.1998  DE 19852071**

(43)  Veröffentlichungstag der Anmeldung:
**17.05.2000  Patentblatt 2000/20**

(73)  Patentinhaber: **Infineon Technologies AG
81669 München (DE)**

(72)  Erfinder:
• **Feurle, Robert
85579 Neubiberg (DE)**

• **Schneider, Helmut
80993 München (DE)**

(74)  Vertreter: **Barth, Stephan Manuel, Dr.
Reinhard-Skuhra-Weise & Partner Gbr,
Patentanwälte
Friedrichstrasse 31
80801 München (DE)**

(56)  Entgegenhaltungen:
**JP-A- 6 342 835        JP-A- 8 304 515
JP-A- 10 253 717**

**Beschreibung**

Die vorliegende Erfindung betrifft einen integrierten Halbleiterchip, bei dem durch externe Beschaltung von ausgewählten Bondpads mit einem Spannungspotential eine von mehreren möglichen Dateneingabe-/Datenausgabe-Organisationsformen voreingestellt ist. Dabei werden nicht alle Bondpads zum Austausch von Eingabedaten und Ausgabedaten infolge der voreingestellten Dateneingabe-/Datenausgabe-Organisationsform für den Normalbetrieb benötigt.

Ein Halbleiterchip weist üblicherweise interne Anschlüsse zu einer oder mehreren auf dem Chip befindlichen integrierten Schaltungen auf, die als sogenannte Bondpads bezeichnet werden. Ist der Halbleiterchip in einem Gehäuse eines Halbleiterbausteins eingebaut, sind die Bondpads alle oder teilweise mit Bonddrähten versehen, die mit Zuleitungen zu externen Anschlüssen des Halbleiterbausteins elektrisch leitend verbunden sind. Solche Anschlüsse können z. B. Anschlüsse von Datenleitungen zu externen Baugruppen sein, die sich beispielsweise auf einer Platine außerhalb des Bausteins befinden. Ein Halbleiterchip kann verschiedenartige interne Anschlüsse aufweisen. Man unterscheidet beispielsweise Daten führende Bondpads, die zum Austausch von Eingabe- und Ausgabedaten dienen (z.B. über oben genannte Datenleitungen), und Bondpads, die durch eine auszuwählende Beschaltungsart beispielsweise einen Betriebsmodus und/oder eine Dateneingabe-/Datenausgabe-Organisationsform des Chips festlegen, hier als Bondoptionpads bezeichnet.

Aufgrund der Produkt- und Anwendungsvielfalt von integrierten Halbleiterschaltungen werden Halbleiterchips nicht ausschließlich für einzelne Anwendungen entwickelt und hergestellt, sondern sind grundlegend für mehrere Anwendungen konzipiert und werden durch geringfügige Anpassungen oder Änderungen auf einzelne Anwendungen zugeschnitten. So kann beispielsweise ein bestimmter Betriebsmodus oder eine von mehreren möglichen Dateneingabe-/Datenausgabe-Organisationsformen nachträglich (nach Herstellung des Chips) festgelegt werden, indem eine bestimmte Anzahl oder Kombination der oben genannten Bondoptionpads über einen externen Anschluß fest mit einem Anschluß für ein externes Spannungspotential verbunden ist. Diese Verbindung zwischen externem Anschluß und Bondpad wird dauerhaft durch "Bonden" (Anschluß eines Bonddrahts an das jeweilige Bondpad) hergestellt und kann nach Einbau in das Gehäuse des Halbleiterbausteins nicht mehr rückgängig gemacht werden.

Die japanische Offenlegungsschrift, JP 8304515 (Kin Taishin) beschreibt eine Halbleiterspeichervorrichtung für einen Spannungstest des Gehäusezustandes. Die Speichervorrichtung weist eine Vielzahl von Bondpads auf, die elektrisch mit einer externen Vorrichtung verbunden sind, zumindest einen internen Spannungsgenerator und zumindest einen Schalter, der zwischen den Bondpads und dem internen Spannungsgenerator angeordnet ist. Dieser mindestens eine Schalter ist während einem Testbetriebsmodus eingeschaltet und während eines normalen Betriebsmodus ausgeschaltet. Abhängig von einem externen Schaltsteuersignal lässt sich der Schalter, gesteuert über einen Schaltkontroller, ein- und ausschalten, sodass damit die gesamte Schaltungsanordnung in einen Testbetrieb oder einen normalen Betriebsmodus gesteuert werden kann. Im Testbetrieb lassen sich eine Anzahl von Spannungstests vornehmen, ohne das dies eine Vergrößerung des Chips bzw. des Gehäuses des Chips zur Folge hat.

Um einen Halbleiterchip nach Einbau in ein Gehäuse eines Halbleiterbausteins testen zu können, mußten bisher Testverfahren und Testprogramme verwendet werden, die auf die jeweils über Bondoptionpads eingestellte Konfiguration eines Chips abgestimmt sind. Je nach Anwendungsvielfalt eines Halbleiterchips erhält man so eine Vielzahl von Testverfahren und Testprogrammen, die sich je nach eingestellter Konfiguration des Chips auch im Zeitbedarf unterscheiden können.

Aufgabe der vorliegenden Erfindung ist es, einen integrierten Halbleiterchip anzugeben, der es ermöglicht, die Variantenvielfalt und den Zeitbedarf eines Testprogramms für den Test des Halbleiterchips zu reduzieren.

Die Aufgabe wird gelöst durch einen integrierten Halbleiterchip nach den Merkmalen des Patentanspruchs 1. Danach werden alle Daten führenden Bondpads mit externen Anschlüssen verbunden ("gebondet"), und es wird eine veränderte Dateneingabe-/Datenausgabe-Organisationsform konfiguriert, so daß im Normalbetrieb nicht benutzte Bondpads im Testbetrieb zum Austausch von Eingabedaten und Ausgabedaten verwendet werden. Vorteilhafte Aus- und Weiterbildungen sind in Unteransprüchen gekennzeichnet. Danach wird bei einem Chip mit über Bondoptionpads voreingestellter Dateneingabe-/Datenausgabe-Organisationsform bei unveränderter externer Beschaltung der Bondoptionpads eine veränderte Dateneingabe-/Datenausgabe-Organisationsform durch eine interne Beschaltung der Bondoptionpads eingestellt. Eine dazu vorgesehene Schaltung wird von einer Steuerungseinrichtung zur Steuerung des Betriebsmodus gesteuert. Damit keine Störeinflüsse im Normalbetrieb eingekoppelt werden, sind nicht benutzte Daten führende Bondpads im Normalbetrieb inaktiv.

Im folgenden wird die Erfindung anhand von in der Zeichnung dargestellten Figuren näher erläutert. Es zeigen:

Figur 1    eine grob schematische Darstellung zweier Halbleiterchips A und B mit Bondpads, die sich in ihrer Dateneingabe-/Datenausgabe-Organisationsform und der Beschaltung der Bondpads unterscheiden,

Figur 2a eine grob schematische Darstellung eines erfindungsgemäßen Halbleiterchips mit Bondpads, der in seiner Dateneingabe-/Datenausgabe-Organisationsform verändert werden kann,

Figur 2b eine Schaltung für ein Bondoptionpad, mit der eine eingestellte Dateneingabe-/Datenausgabe-Organisationsform nachträglich verändert werden kann.

Figur 3 eine Schaltung für ein Daten führendes Bondpad mit zwei Treiberstufen zum Austausch von Eingabedaten und Ausgabedaten

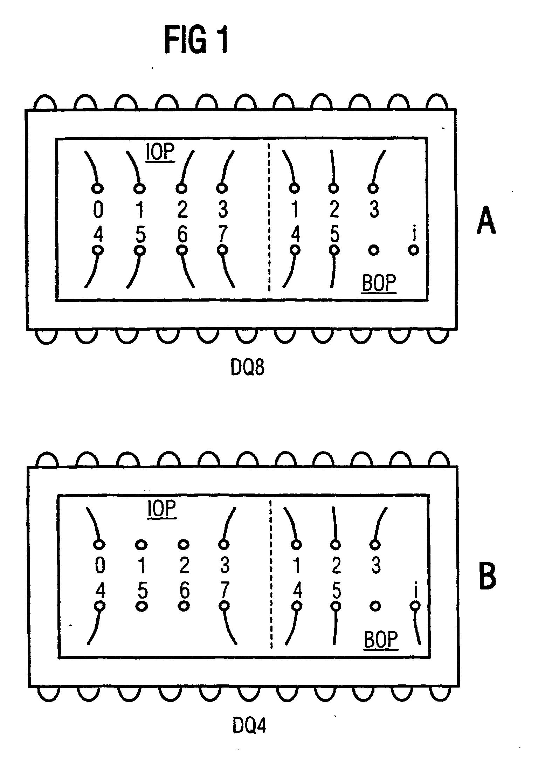

Figur 1 zeigt eine grob schematische, nicht maßstabsgetreue Darstellung zweier gleich aufgebauter Halbleiterchips A und B mit externen Anschlüssen und einer beispielhaften Anzahl von Bondpads, die sich in ihrer Dateneingabe-/Datenausgabe-Organisationsform und der Beschaltung der Bondpads unterscheiden. Es sind zwei unterschiedliche Arten von Bondpads dargestellt: Zum einen Bondpads IOP zum Austausch von Eingabedaten und Ausgabedaten und Bondpads zur Einstellung der Dateneingabe-/Datenausgabe-Organisationsform, hier als Bondoptionpads,BOP bezeichnet. Jeder der beiden Chips weist 8 Bondpads IOP zum Austausch von Eingabedaten und Ausgabedaten auf. Der Chip A weist eine hier als DQ8 bezeichnete Dateneingabe-/Datenausgabe-Organisationsform auf, bei der alle 8 Bondpads IOP 0 bis 7 in einem Normalbetrieb des Chips benutzt werden. Das heißt es liegen 8 Datenbits parallel vor. Diese Organisationsform wird durch eine feste Verbindung von ausgewählten Bondoptionpads BOP mit jeweils einem Anschluß für ein externes Spannungspotential eingestellt. Beispielsweise werden die Bondoptionpads BOP 1 bis 5 "gebondet" und mit einem externen Spannungspotential beaufschlagt (üblicherweise Massepotential "GND"). Das Bondoptionpad BOPi bleibt unbeschaltet.

Der Chip B weist eine hier als DQ4 bezeichnete Dateneingabe-/Datenausgabe-Organisationsform auf, bei der nur 4 der 8 Bondpads IOP 0 bis 7 in einem Normalbetrieb des Chips benutzt werden. Das heißt es liegen 4 Datenbits parallel vor. Die unbenutzten Bondpads, hier IOP 1, 2, 5, 6, sind üblicherweise nicht "gebondet". Diese Organisationsform wird beispielsweise durch eine unveränderte externe Beschaltung der Bondoptionpads BOP 1 bis 5 und durch eine feste Verbindung des Bondoptionpads BOPi mit einem Anschluß für ein externes Spannungspotential eingestellt.

Bei einem Test ist es erforderlich, für beide Halbleiterchips A und B zwei unterschiedliche Testprogramme zu verwenden, die die voreingestellte Dateneingabe-/Datenausgabe-Organisationsform des jeweiligen Chips unterstützen. Außerdem weisen der Testbetrieb des Chips A und der Testbetrieb des Chips B unterschiedliche Testzeiten auf. Da bei gleicher Speicherkapazität der Chip A aufgrund der größeren Datenwortbreite von 8 Bit einen kleineren Adreßbereich als der Chip B mit dessen Datenwortbreite von 4 Bit aufweist, ist der Zeitbedarf im Testbetrieb beim Chip B höher als beim Chip A. Aus den genannten Gründen ist es bislang notwendig, mehrere organisationsspezifische Testprogramme zu erstellen und zu pflegen, außerdem müssen je nach Organisationsform vergleichsweise hohe Testzeiten in Kauf genommen werden.

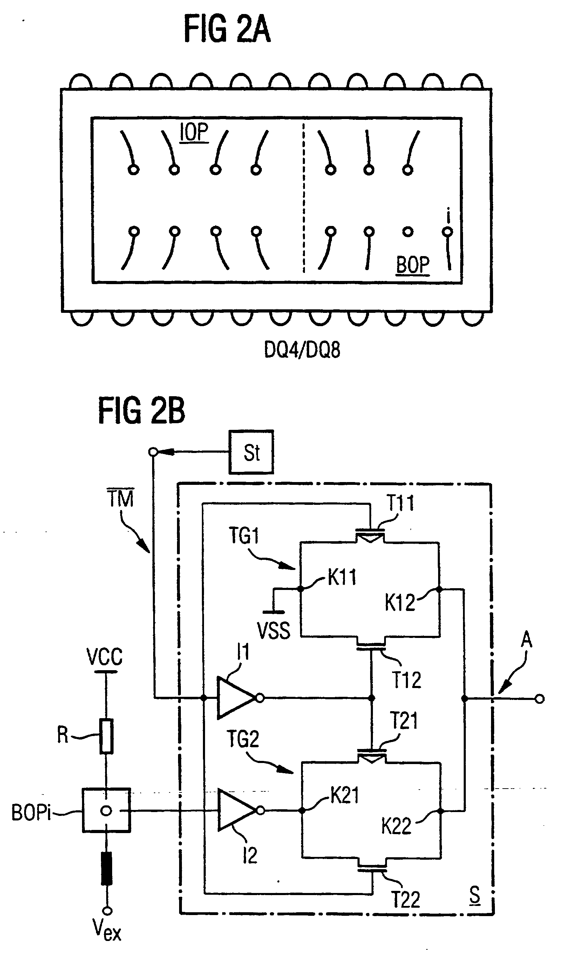

Figur 2a zeigt eine schematische Darstellung eines erfindungsgemäßen Halbleiterchips mit Bondpads, der in seiner Dateneingabe-/Datenausgabe-Organisationsform verändert werden kann. Alle Bondpads IOP sind mit externen Anschlüssen verbunden und das Bondoptionpad BOPi ist neben den Bondoptionpads BOP 1 bis 5 mit einem externen Spannungspotential beschaltet. Daraus folgt, daß der Chip im Normalbetrieb in der DQ4 Organisationsform wie der Chip B in Figur 1 betrieben wird.

Um im Testbetrieb des Chips die Testzeit zu reduzieren, wird der Chip während des Testbetriebs auf eine veränderte Dateneingabe-/Datenausgabe-Organisationsform umgestellt, ohne daß die externe Beschaltung der Bondoptionpads BOP verändert wird. Aus den oben erwähnten Gründen wird hier eine DQ8 Organisationsform wie bei Chip A aus Figur 1 gewählt. Bei diesem werden alle Bondpads IOP 0 bis 7 zum Austausch von Eingabeund Ausgabedaten benutzt. D. h. im Normalbetrieb in der DQ4 Organisationsform nicht benutzte Bondpads IOP werden in einem Testbetrieb verwendet. Um eine veränderte Dateneingabe-/ Datenausgabe-Organisationsform bei unveränderter externer Beschaltung der Bondoptionpads zu erhalten, wird die externe Beschaltung des Bondoptionpads BOPi, durch das die Voreinstellung der Dateneingabe-/Datenausgabe-Organisationsform mittels externer Beschaltung steuerbar ist, durch eine interne Beschaltung in ihrer Wirksamkeit aufgehoben. Diese interne Beschaltung des Bondoptionpads BOPi wird beispielsweise durch ein Steuersignal TM einer übergeordneten Steuerungseinrichtung St zur Steuerung des Betriebsmodus gesteuert. D. h. die Steuerungseinrichtung St gibt durch ein Steuersignal $\overline{TM}$ vor, ob der Halbleiterchip im Normalbetrieb (DQ4 bei $\overline{TM}$ = 1, externe Beschaltung ist wirksam) oder im Testbetrieb (DQ8 bei $\overline{TM}$ = 0, externe Beschaltung ist nicht wirksam) betrieben wird. Da die externe Beschaltung der Bondoptionpads im Testbetrieb nicht wirksam ist, kann ein Testbetrieb unabhängig vom externen Spannungspotential erfolgen.

Eine beispielhafte Ausführungsform ist in Figur 2b dargestellt. Das Bondoptionpad BOPi aus Figur 2a ist mit einer Schaltung S beschaltet. Ein Eingangssignal der Schaltung S bildet das Steuersignal $\overline{TM}$ der übergeordneten Steuerung des Betriebsmodus St. Das Ausgangssignal A der Schaltung S bestimmt mit den Zuständen "log. 0" und "log. 1" die Dateneingabe-/Datenausgabe-Organisationsform des Halbleiterchips. Bei A = "log. 0" ($\overline{TM}$ = 0) ist die DQ8 Organisationsform eingestellt, bei A = "log. 1" ($\overline{TM}$ = 1) ist die DQ4 Organisationsform eingestellt. Der Zustand "log. 1" entspricht dabei einem Versorgungspotential VCC, der Zustand "log. 0" einem Bezugspotential VSS. Das externe Spannungspotential Vex und das Bezugspotential VSS nehmen hier das Potential eines Massepotentials des Halbleiterbausteins an (VSS = Vex = "GND"). Die Transmission-Gates TG1 und TG2 der Schaltung S sind abwechselnd aktiviert. Wird das Bondoptionpad BOPi nicht mit dem externen Spannungspotential Vex beschaltet, d. h. das Bondoptionpad BOPi ist nicht "gebondet", nimmt dieses über den als möglichst hochohmig auszuführenden Widerstand R das Versorgungspotential VCC an. Damit nimmt das Ausgangssignal A der Schaltung S in jedem Fall den Zustand "log. 0" an.

Die Schaltung S weist zwei Transmission-Gates TG1, TG2 auf, die jeweils zwei Transistoren T11, T12 beziehungsweise T21, T22 umfassen, die mit ihren Drain-Source-Strecken parallel geschaltet sind und an je zwei Kopplungsknoten K11,12 beziehungsweise K21, K22 miteinander verbunden sind. Das Gate des ersten Transistors T11 des ersten Transmission-Gates TG1 und das Gate des zweiten Transistors T22 des zweiten Transmission-Gates TG2 sind mit dem Anschluß für das Steuersignal $\overline{TM}$ verbunden. Das Gate des zweiten Transistors T12 des ersten Transmission-Gates TG1 und das Gate des ersten Transistors T21 des zweiten Transmission-Gates TG2 sind über einen ersten Inverter I1 mit dem Anschluß für das Steuersignal $\overline{TM}$ verbunden. Der erste Kopplungsknoten K11 der Transistoren T11, T12 des ersten Transmission-Gates TG1 ist an einem Bezugspotential des Halbleiterchips VSS angeschlossen. Der zweite Kopplungsknoten K12 der Transistoren T11, T12 des ersten Transmission-Gates TG1 bildet den Anschluß für Ausgangssignal A, das zur Einstellung der Dateneingabe-/Datenausgabe-Organisationsform DQ4 beziehungsweise DQ8 dient. Der erste Kopplungsknoten K21 der Transistoren T21, T22 des zweiten Transmission-Gates TG2 ist über einen zweiten Inverter I2 mit dem Bondoptionpad BOPi verbunden, der zweite Kopplungsknoten K22 der Transistoren T21, T22 des zweiten Transmission-Gates TG2 ist an den Anschluß für das Ausgangssignal A angeschlossen. Das Bondoptionpad BOPi ist mit einem externen Versorgungspotential Vex und über einen Widerstand R mit einem internen Versorgungspotential VCC des Halbleiterchips verbunden. Die Transistoren T11, T12, T21, T22 der Transmission-Gates TG1, TG2 sind vorteilhafterweise Feldeffekttransistoren, wobei der jeweils erste Transistor T11, T21 vom p-Kanal-Typ und der jeweils zweite Transistor T12, T22 vom n-Kanal-Typ ist.

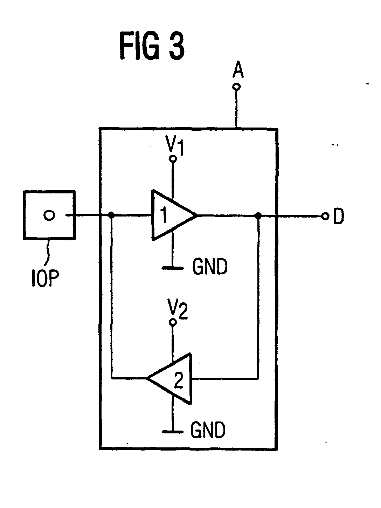

Da, wie aus Figur 2a ersichtlich, die Bondpads IOP 1, 2, 5, 6 im Gegensatz zu Chip B aus Figur 1 "gebondet" und mit externen Anschlüssen verbunden sind, muß durch eine interne Beschaltung der betroffenen Bondpads IOP sichergestellt werden, daß im Normalbetrieb keine störenden Spannungspotentiale oder anderweitige Störeinflüsse in die integrierten Schaltungen des Chips über die Bondpads IOP eingekoppelt werden. Dies wird im allgemeinen durch Schaltmittel am Eingang des jeweiligen Bondpads IOP erreicht, die im Normalbetrieb inaktiv geschaltet sind. Eine beispielhafte Schaltung für ein Bondpad IOP ist in Figur 3 dargestellt, in der die Schaltmittel als Treiberstufen ausgeführt sind. Ein Treiber 2 ist eingangsseitig mit einer Datenleitung D des Chips und ausgangsseitig mit dem Bondpad IOP verbunden. Der Treiber 2 übernimmt im aktiven Zustand die Funktion eines Ausgangstreibers. Ein Treiber 1 ist eingangsseitig mit dem Bondpad IOP und ausgangsseitig mit der Datenleitung D verbunden. Der Treiber 1 übernimmt im aktiven Zustand die Funktion eines Empfängers und Eingangstreibers. Beide Treiber sind weiterhin mit Versorgungspotentialen V1 beziehungsweise V2 und jeweils einem Masseanschluß verbunden. Das Ausgangssignal A der Schaltung S aus Figur 2b wirkt als Steuersignal der Schaltung. Die Treiber 1 und 2 der Bondpads IOP, die im Normalbetrieb nicht benutzt werden, sind während des Normalbetriebs inaktiv (A = "log. 1"). Im Testbetrieb sind die Treiber 1 und 2 dieser Bondpads sowie der übrigen Bondpads IOP für den Austausch von Eingabedaten und Ausgabedaten zur Aktivierung freigegeben (A = "log. 0"). Da die integrierten Schaltungen des Halbleiterchips für unterschiedliche Dateneingabe-/Datenausgabe-Organisationsformen konzipiert werden und erst durch nachträgliches "Bonden" die jeweilige Organisationsform eingestellt wird, sind alle Bondpads IOP bereits mit den erwähnten Treiberstufen versehen.

Die dauerhafte Einstellung einer Dateneingabe-/Datenausgabe-Organisationsform kann anstelle der Bondoptionpads BOP auch beispielsweise über Laser Fuses oder andere dauerhaft programmierbare Elemente (z.B. chemisch, mechanisch, thermisch programmierbare Elemente) erfolgen, die vor Einbau in ein Gehäuse eines Halbleiterbausteins durchtrennt werden. Beispielhafte Schaltungen finden sich z.B. bei sogenannten Redundanzdecodern in integrierten Schaltungen von Speicherchips.

**Patentansprüche**

1. Integrierter Halbleiterchip mit einer Vielzahl von Bondpads (IOP; BOP) zum Austausch von Eingabedaten und Ausgabedaten, mit

   (a) Bondpads (IOP) einer ersten Gruppe, die für den Austausch von Eingabedaten und Ausgabedaten in einem ausgewählten Normalbetrieb benutzt werden,

   (b) Bondpads (IOP) einer zweiten Gruppe, die nicht zum Austausch von Eingabedaten und Ausgabedaten in dem ausgewählten Normalbetrieb benutzt werden,

(c) Bondpads (BOP) einer dritten Gruppe, mit zumindest einem Bondoptionspad zum Einstellen einer Dateneingabe/Datenausgabe-Organisationsform (DQ4; DQ8) für einen Normalbetrieb aus einer Vielzahl von Dateneingabe/Datenausgabe-Organisationsformen (DQ4, DQ8),

(d) wobei die Bondpads (IOP; BOP) der ersten, zweiten und dritten Gruppe mit entsprechenden externen Anschlüssen verbunden sind,

(e) wobei der Halbleiterchip in einem Testbetrieb betreibbar ist und in diesem Testbetrieb eine veränderte Dateneingabe-/Datenausgabe-Organisationsform derart aufweist, dass die Bondpads (IOP) der zweiten Gruppe im Testbetrieb zum Austausch von Eingabedaten und Ausgabedaten vorgesehen sind, und

(f) wobei die Anzahl der Bondpads (IOP) der ersten Gruppe bzw. der zweiten Gruppe ohne eine Veränderung der entsprechenden internen und externen Anschlüsse abhängig von der Wahl der Dateneingabe-/Datenausgabe-Organisationsform veränderbar ist.

2.  Integrierter Halbleiterchip nach Anspruch 1 mit einem oder mehreren Bondoptionpads (BOP) zur Einstellung einer Dateneingabe-/Datenausgabe-Organisationsform,
    **dadurch gekennzeichnet, daß**

    -   eine von mehreren möglichen Dateneingabe-/Datenausgabe-Organisationsformen (DQ4; DQ8) durch feste Verbindung eines oder mehrerer Bondoptionpads (BOP) mit jeweils einem Anschluß für ein externes Spannungspotential ($V_{ex}$) mittels Bonddrähten für einen Normalbetrieb voreingestellt ist,
    -   der Halbleiterchip während eines Testbetriebs eine veränderte Dateneingabe-/Datenausgabe-Organisationsform (DQ8)auf= weist bei unveränderter externer Beschaltung der Bondoptionpads (BOP).

3.  Integrierter Halbleiterchip nach Anspruch 2,
    **dadurch gekennzeichnet, daß**
    die veränderte Dateneingabe-/Datenausgabe-Organisationsform (DQ8) durch eine interne Beschaltung der Bondoptionpads (BOP) eingestellt wird, die die Wirksamkeit einer vorhandenen festen Verbindung eines oder mehrerer Bondoptionpads (BOP) mit jeweils einem Anschluß für ein externes Spannungspotential ($V_{ex}$) aufhebt.

4.  Integrierter Halbleiterchip nach Anspruch 3,
    **dadurch gekennzeichnet, daß**

die Einstellung der veränderten Dateneingabe-/Datenausgabe-Organisationsform (DQ8) durch ein Steuersignal ($\overline{TM}$) gesteuert wird, das von einer Steuerungseinrichtung (St) zur Steuerung des Betriebsmodus erzeugt wird.

5.  Integrierter Halbleiterchip nach Anspruch 4,
    **dadurch gekennzeichnet, daß**
    eine Schaltung (S) für ein Bondoptionpad (BOPi), durch das die Voreinstellung der Dateneingabe-/Datenausgabe-Organisationsform mittels externer Beschaltung steuerbar ist, vorgesehen ist mit folgenden Merkmalen:

    -   die Schaltung (S) weist zwei Transmission-Gates (TG1,TG2) auf, die jeweils zwei Transistoren (T11,T12; T21,T22) umfassen, die mit ihren Drain-Source-Strekken parallel geschaltet sind und an je zwei Kopplungsknoten (K11,K12; K21,K22) miteinander verbunden sind,
    -   das Gate des ersten Transistors (T11) des ersten Transmission-Gates (TG1) und das Gate des zweiten Transistors (T22) des zweiten Transmission-Gates (TG2) sind mit dem Anschluß für das Steuersignal ($\overline{TM}$) verbunden,
    -   das Gate des zweiten Transistors (T12) des ersten Transmission-Gates (TG1) und das Gate des ersten Transistors (T21) des zweiten Transmission-Gates (TG2) sind über einen ersten Inverter (I1) mit dem Anschluß für das Steuersignal ($\overline{TM}$) verbunden,
    -   der erste Kopplungsknoten (K11) der Transistoren (T11,T12) des ersten Transmission-Gates (TG1) ist an einem Bezugspotential des Halbleiterchips (VSS) angeschlossen, der zweite Kopplungsknoten (K12) der Transistoren (T11,T12) des ersten Transmission-Gates (TG1) bildet den Anschluß für ein Ausgangssignal (A) zur Einstellung der Dateneingabe-/Datenausgabe-Organisationsform (DQ4; DQ8),
    -   der erste Kopplungsknoten (K21) der Transistoren (T21,T22) des zweiten Transmission-Gates (TG2) ist über einen zweiten Inverter (I2) mit dem Bondoptionpad (BOPi) verbunden, der zweite Kopplungsknoten (K22) der Transistoren (T21,T22) des zweiten Transmission-Gates (TG2) ist an den Anschluß für das Ausgangssignal (A) angeschlossen,
    -   das Bondoptionpad (BOPi) ist mit einem externen Versorgungspotential ($V_{ex}$) und über einen Widerstand (R) mit einem internen Versorgungspotential (VCC) des Halbleiterchips verbunden,
    -   die Transistoren (T11,T12,T21,T22) der Transmission-Gates (TG1,TG2) sind Feldeffekttransistoren, wobei die jeweils ersten Transistoren (T11,T21) und die jeweils zweiten Transistoren (T12,T22) komplementären Kanaltyps sind.

6. Integrierter Halbleiterchip nach einem der vorhergehenden Ansprüche mit zwei Treiberstufen (1, 2) am Eingang der Bondpads (IOP) zum Austausch von Eingabedaten und Ausgabedaten,
**dadurch gekennzeichnet, daß**
die Treiberstufen (1, 2) der Bondpads (IOP) zum Austausch von Eingabedaten und Ausgabedaten, die im Normalbetrieb nicht benutzt werden, während des Normalbetriebs inaktiv sind und während des Testbetriebs zur Aktivierung freigegeben sind.

**Claims**

1. An integrated semiconductor chip having a multiplicity of bonding pads (IOP; BOP) for the exchange of input data and output data, having

    (a) bonding pads (IOP) of a first group which are used for the exchange of input data and output data in a selected normal mode,

    (b) bonding pads (IOP) of a second group which are not used for the exchange of input data and output data in the selected normal mode,

    (c) bonding pads (BOP) of a third group, having at least one bonding option pad for setting a data input/data output organizational form (DQ4; DQ8) for a normal mode from a multiplicity of data input/data output organizational forms (DQ4, DQ8),

    (d) the bonding pads (IOP; BOP) of the first, second and third groups being connected to corresponding external terminals,

    (e) the semiconductor chip being able to be operated in a test mode and having an altered data input/data output organizational form in this test mode in such a way that the bonding pads (IOP) of the second group are provided for the exchange of input data and output data in the test mode, and

    (f) it being possible to alter the number of bonding pads (IOP) of the first group or of the second group without altering the corresponding internal and external terminals depending on the choice of the data input/data output organizational form.

2. The integrated semiconductor chip as claimed in claim 1 having one or more bonding option pads (BOP) for setting a data input/data output organizational form,
**characterized in that**

    - one of a plurality of possible data input/data output organizational forms (DQ4; DQ8) is preset for a normal mode by fixed connection of one or more bonding option pads (BOP) to a respective terminal for an external voltage potential (Vex) by means of bonding wires,
    - the semiconductor chip has an altered data input/data output organizational form (DQ8) during a test mode, with unchanged external wiring of the bonding option pads (BOP).

3. The integrated semiconductor chip as claimed in claim 2,
**characterized in that**
the altered data input/data output organizational form (DQ8) is set by internal wiring of the bonding option pads (BOP) which cancels the efficacy of an existing fixed connection of one or more bonding option pads (BOP) to a respective terminal for an external voltage potential ($V_{ex}$).

4. The integrated semiconductor chip as claimed in claim 3,
**characterized in that**
the setting of the altered data input/data output organizational form (DQ8) is controlled by a control signal ([equation]) generated by a control device (St) for controlling the operating mode.

5. The integrated semiconductor chip as claimed in claim 4,
**characterized in that**
provision is made of a circuit (S) for a bonding option pad (BOPi), by which the presetting of the data input/data output organizational form can be controlled by means of external wiring, having the following features:

    - the circuit (S) has two transmission gates (TG1, TG2) each comprising two transistors (T11, T12; T21, T22), which are connected in parallel by their drain-source paths and are connected to one another at in each case two coupling nodes (K11, K12; K21, K22),
    - the gate of the first transistor (T11) of the first transmission gate (TG1) and the gate of the second transistor (T22) of the second transmission gate (TG2) are connected to the terminal for the control signal ([equation]),
    - the gate of the second transistor (T12) of the first transmission gate (TG1) and the gate of the first transistor (T21) of the second transmission gate (TG2) are connected to the terminal for the control signal ([equation]) via a first inverter (I1),
    - the first coupling node (K11) of the transistors (T11, T12) of the first transmission gate (TG1) is connected to a reference-ground potential of the semiconductor chip (VSS), and the second coupling node (K12) of the transistors (T11, T12) of the first transmission gate (TG1) forms the terminal for an output signal (A) for setting the data input/data output organizational form (DQ4; DQ8),

- the first coupling node (K21) of the transistors (T21, T22) of the second transmission gate (TG2) is connected to the bonding option pad (BOPi) via a second inverter (I2), and the second coupling node (K22) of the transistors (T21, T22) of the second transmission gate (TG2) is connected to the terminal for the output signal (A),

- the bonding option pad (BOPi) is connected to an external supply potential (Vex) and, via a resistor (R), to an internal supply potential (VCC) of the semiconductor chip,

- the transistors (T11, T12, T21, T22) of the transmission gates (TG1, TG2) are field-effect transistors, the respective first transistors (T11, T21) and the respective second transistors (T12, T22) being of complementary channel types.

6. The integrated semiconductor chip as claimed in one of the preceding claims having two driver stages (1, 2) at the input of the bonding pads (IOP) for the exchange of input data and output data,
**characterized in that**
the driver stages (1, 2) of the bonding pads (IOP) for the exchange of input data and output data which are not used in the normal mode are inactive during the normal mode and are enabled for activation during the test mode.

**Revendications**

1. Puce de semi-conducteur intégrée dotée d'une pluralité de plages de connexion (IOP ; BOP) servant à échanger des données d'entrée et des données de sortie, laquelle comporte :

(a) des plages de connexion (IOP) d'un premier groupe qui sont utilisées pour échanger des données d'entrée et des données de sortie dans le cadre d'un fonctionnement normal sélectionné ;
(b) des plages de connexion (IOP) d'un deuxième groupe qui ne sont pas utilisées pour échanger des données d'entrée et des données de sortie dans le cadre du fonctionnement normal sélectionné ;
(c) des plages de connexion (BOP) d'un troisième groupe comportant au moins une plage de connexion optionnelle et servant à régler, parmi une pluralité de configurations d'entrée et de sortie (DQ4 ; DQ8), une configuration d'entrée et de sortie (DQ4 ; DQ8) pour un fonctionnement normal ;
(d) les plages de connexion (IOP ; BOP) des premier, deuxième et troisième groupes étant reliées à des bornes externes correspondantes ;
(e) la puce de semi-conducteur pouvant fonctionner en mode "essai" et ayant dans ce mode "essai" une configuration d'entrée et de sortie modifiée telle que les plages de connexion (IOP) du deuxième groupe puissent servir à échanger des données d'entrée et des données de sortie en mode "essai" ; et
(f) le nombre de plages de connexion (IOP) du premier groupe et/ou du deuxième groupe étant modifiable, sans modifier les bornes internes et externes correspondantes, en fonction du choix de la configuration d'entrée et de sortie.

2. Puce de semi-conducteur intégrée selon la revendication 1, comportant une ou plusieurs plages de connexion optionnelle (BOP) servant à régler une configuration d'entrée et de sortie,
**caractérisée en ce que** :

- une configuration d'entrée et de sortie parmi plusieurs possibles (DQ4 ; DQ8) est préréglée pour un mode de fonctionnement normal au moyen de fils de connexion en reliant de manière fixe une ou plusieurs plages de connexion optionnelle (BOP) chacune à une borne destinée à un potentiel électrique extérieur (Vex) ;
- la puce de semi-conducteur présente, pendant un fonctionnement en mode "essai", une configuration d'entrée et de sortie (DQ8) modifiée, le câblage externe des plages de connexion optionnelle (BOP) étant inchangé.

3. Puce de semi-conducteur intégrée selon la revendication 2,
**caractérisée en ce que** la configuration d'entrée et de sortie (DQ8) modifiée est réglée au moyen d'un câblage interne des plages de connexion optionnelle (BOP) qui rend ineffective une liaison fixe existante d'une ou plusieurs plages de connexion optionnelle (BOP) avec chaque fois une borne destinée à un potentiel électrique extérieur (Vex).

4. Puce de semi-conducteur intégrée selon la revendication 3,
**caractérisée en ce que** le réglage de la configuration d'entrée et de sortie (DQ8) modifiée est commandé à l'aide d'un signal de commande (TM) qui est produit par un dispositif de commande (St) servant à commander le mode de fonctionnement.

**5.** Puce de semi-conducteur intégrée selon la revendication 4,

    **caractérisée en ce qu'**il est prévu un circuit (S) pour une plage de connexion optionnelle (BOPi) à l'aide de laquelle le préréglage de la configuration d'entrée et de sortie peut être commandé au moyen du câblage externe, lequel circuit a les particularités suivantes :

- le circuit (S) comporte deux grilles de transmission (TG1, TG2) qui comprennent chacune deux transistors (T11, T12 ; T21, T22) qui sont montés en parallèle par leurs intervalles drain-source et qui sont reliés ensemble, chacun par deux noeuds de couplage (K11, K12 ; K21, K22) ;
- la grille du premier transistor (T11) de la première grille de transmission (TG1) et la grille du deuxième transistor (T22) de la deuxième grille de transmission (TG2) sont reliées à la borne destinée au signal de commande ($\overline{TM}$) ;
- la grille du deuxième transistor (T12) de la première grille de transmission (TG1) et la grille du premier transistor (T21) de la deuxième grille de transmission (TG2) sont reliées à la borne destinée au signal de commande ($\overline{TM}$) par l'intermédiaire d'un premier inverseur (I1) ;
- le premier noeud de couplage (K11) des transistors (T11, T12) de la première grille de transmission (TG1) est raccordée à un potentiel de référence de la puce de semi-conducteur (VSS) ; le deuxième noeud de couplage (K12) des transistors (T11, T12) de la première grille de transmission (TG1) forme la borne destinée à un signal de sortie (A) servant à régler la configuration d'entrée et de sortie (DQ4 ; DQ8) ;
- le premier noeud de couplage (K21) des transistors (T21, T22) de la deuxième grille de transmission (TG2) est relié à la plage de connexion optionnelle (BOPi) par l'intermédiaire d'un deuxième inverseur (I2) ; le deuxième noeud de couplage (K22) des transistors (T21, T22) de la deuxième grille de transmission (TG2) est raccordé à la borne destinée au signal de sortie (A) ;
- la plage de connexion optionnelle (BOPi) est reliée à un potentiel d'alimentation extérieur (Vex) et, par l'intermédiaire d'une résistance (R), à un potentiel d'alimentation interne (VCC) de la puce de semi-conducteur ;
- les transistors (T11, T12, T21, T22) des grilles de transmission (TG1, TG2) sont des transistors à effet de champ, chacun des premiers transistors (T11, T21) et chacun des deuxièmes transistors (T12, T22) étant d'un type de canal complémentaire.

**6.** Puce de semi-conducteur intégrée selon l'une des revendications précédentes, comportant deux étages d'attaque (1, 2) à l'entrée des plages de connexion (IOP) servant à échanger des données d'entrée et des données de sortie,

    **caractérisée en ce que** les étages d'attaque (1, 2) des plages de connexion (IOP) servant à échanger des données d'entrée et des données de sortie qui ne sont pas utilisées en fonctionnement normal sont inactifs pendant le fonctionnement normal et peuvent être activés pendant le fonctionnement en mode "essai".

# FIG 1

A — DQ8

B — DQ4

## FIG 2A

DQ4/DQ8

## FIG 2B

FIG 3